# EUROPÄISCHE PATENTSCHRIFT

(11) **EP 2 135 230 B1**
(45) Veröffentlichungstag und Bekanntmachung des Hinweises auf die Patenterteilung: **20.02.2013**
(21) Anmeldenummer: 07712502.9
(22) Anmeldetag: 09.03.2007
(51) Int. Cl.: G08G 1/02, E01F 11/00

(54) **VORRICHTUNG ZUM ERMITTELN VON DATEN**
DEVICE FOR OBTAINING DATA
DISPOSITIF DE DÉTERMINATION DE DONNÉES

(43) Veröffentlichungstag der Anmeldung: 23.12.2009
(73) Patentinhaber: DataCollect Traffic Systems GmbH & Co. KG, 50170 Kerpen (DE)
(72) Erfinder: OVERZIER, Dirk, 50226 Frechen (DE); HERRLICH, Christof, 50171 Kerpen (DE)
(74) Vertreter: Bauer Vorberg Kayser Patentanwälte
(86) Internationale Anmeldenummer: PCT/EP2007/052254
(87) Internationale Veröffentlichungsnummer: WO 2008/110200

(56) Entgegenhaltungen:
- DE-A1-102004 036 729
- DE-A1-102005 041 671
- DE-A1-102006 014 148
- DE-U1- 29 901 878
- US-A- 3 750 127
- US-A- 3 911 390

## Beschreibung

Die vorliegende Erfindung betrifft ein Datenermittlungssystem.

Die Ermittlung von Daten bezieht sich beispielsweise auf die Ermittlung klimatischer Daten oder auf die Ermittlung elementbezogener Daten. Die Ermittlung elementbezogener Daten wird beispielsweise für Verkehrsanalysen eingesetzt, wobei die genannten Elemente dann durch sich bewegende Objekte (z.B. Fahrzeuge) gebildet sind. Die Vorrichtung dient dann zum Beispiel zur Bestimmung der Anwesenheit, Position, Menge, Art (Klassifikation) sowle zur Geschwindigkeitsmessung von bewegten Objekten oder Fahrzeugen aller Art.

Geräte zur Verkehrsanalyse sind bekannt und werden weltweit seit längerer Zeit eingesetzt. Hintergrund solcher Vorrichtungen ist der Wunsch, Verkehrsströme zahlenmäßig erfassen und damit planbar machen zu können. Verkehrsplaner weltweit benötigen zur Durchführung ihrer Planungsaufgaben verlässliche Verkehrsdaten von Knotenpunkten. Hierzu werden in einem definierten Zeitraum alle Fahrzeuge, welche z.B. In den Knotenpunkt einfahren, fahrspurbezogen gezählt. Diese Daten werden später z.B. zur Optimierung von Ampelphasen, Grüne Welle, Umbaumaßnahmen etc. herangezogen.

Das Ermitteln von fahrzeugbezogenen Daten kann sich, wie bereits ausgeführt lediglich auf das Zählen von Fahrzeugen beschränken. Im einfachsten Fall zählt eine Person vorbeifahrende Fahrzeuge und dokumentiert die gewonnenen Ergebnisse. Bei einer derartigen Handerfassung werden die Fahrzeuge von der Zählperson visuell erfasst, und dann in einen Handcomputer oder auf ein Zählblatt übertragen. Die Datenqualität hängt dabei maßgeblich von der Zählperson ab und nimmt mit zunehmender Zählzeit aufgrund von beispielsweise Ermüdung drastisch ab. Daher können manuelle Knotenerfassungen nur in Kurzzeiträumen von etwa je 2 Stunden durchgeführt werden, weswegen bei Verkehrsknotenpunkten pro Schicht ca. 3-4 Personen benötigt werden, um auch bei Verkehrsspitzen eine hinreichend genaue Erfassung zu gewährleisten. Nachteilig ist dabei natürlich, dass die jeweilige Person über die gesamte Zeitdauer vor Ort sein muss. Dies ist je nach Wind- und Wetterlage unangenehm. Auch können Nebel oder Dunkelheit die Zählung erschweren.

Oftmals werden Fahrzeuge nicht nur gezählt, sondern auch klassifiziert. Dies bedeutet, dass unterschieden wird, ob es sich bei dem Fahrzeug beispielsweise um einen Pkw, einen Lkw oder ein Radfahrer handelt. Eine derartige Klassifizierung stellt entsprechend höhere Ansprüche an die Person, die die Fahrzeuge zählt oder aber die Vorrichtung, die die Person bei dieser Tätigkeit unterstützen oder ersetzen soll.

Schließlich kann die Ermittlung fahrzeugbezogener Daten auch eine Messung der Geschwindigkeit beinhalten.

Bei der Pneumatikerfassung werden auf der Fahrbahnoberfläche Gummischläuche installiert. Der Pneumatikschlauch wir über die Fahrbahn gespannt und mittels Nägeln auf der Fahrbahndecke fixiert. Durch die Überfahrt eines Reifens wird ein Luftdruckimpuls erzeugt welcher vom Erfassungsgerät registriert und gespeichert wird. Die maximale Schlauchlänge sollte dabei 10 m nicht überschreiten, da sonst der Druckimpuls zu schwach wird. Für die Erfassung einer Kreuzung müssen mindestens vier Erfassungsgeräte eingesetzt werden, da nicht alle Schläuche zu einem Erfassungsgerät geführt werden können. Eine Fahrspurtrennung ist mit dieser Methode nicht möglich. Die Pneumatikschläuche sind gut sichtbar, werden gerne zerstört und eine genauere Erfassung des Verkehrs ist erst ab 15-20 km/h möglich. Geschwindigkeitsmessungen bedingen den Einsatz von mindestens zwei Schläuchen und sind beim Überfahren deutlich spürbar, insbesondere für Radfahrer. Der Sensor ist gut sichtbar was bei den Verkehrsteilnehmern oft zu Irritationen führt (abruptes Abbremsen und Ausweichen, bewusstes Bremsen auf den Schläuchen um diese zu zerstören). Bei der Überfahrung dieses Sensors entsteht ein Schlaggeräusch, welches in Wohngebieten speziell nachts als störend empfunden wird. Der Sensor unterliegt insgesamt einem hohen Verschleiß.

Bei der Videoerfassung wird ein Videobild digital ausgewertet und die Fahrzeugmengen abgespeichert. Die Videokamera muss so Installiert sein das sie den Knotenpunkt aus der vogelperspektive erfassen kann, um Überschattungen von Fahrzeugen zu vermeiden (LKW verdeckt PKW). Dafür ist entweder ein begehbares hohes Gebäude oder ein hoher Mast mit bis zu 30-40 m Höhe notwendig. Beides ist selten vorhanden. Des Weiteren ist die Videoerfassung wetterabhängig, d.h. bei starker Sonne, Regen, Nebel oder in der Nacht nimmt die Erfassungsqualität stark ab.

Bei der Induktionserfassung werden die Fahrzeuge von Induktionssensoren, die in der Fahrbahn eingelassen oder auf der Fahrbahnoberfläche montiert sind, erfasst. An vielen Knotenpunkten sind keine Induktionssensoren installiert oder können nicht zur Datenerfassung herangezogen werden, da sie für die Signalsteuerung der Ampelanlagen benötigt werden. Mobile Induktionssensoren sind teuer (ca. 1000 EUR pro Fahrspur), die Erfassung einer Kreuzung macht damit eine Investition von zurzeit ca. 12 000 EUR für Gerätetechnik notwendig. Hinzu kommt, dass die Induktionsschleifen auf Dauer durch die Belastung beispielsweise durch LKW zerstört werden.

Mobile Induktionsschleifen bestehen aus einem Draht, welcher mit 2-3 Windungen in rechteckiger oder quadratischer Form auf der Fahrbahn fixiert wird. Die Montage ist aufwendig und kann nur von Fachpersonal ausgeführt werden. Die Induktionsschleife kann theoretisch auch in der Fahrbahn verlegt werden, dafür muss die Fahrbahn jedoch aufgefräst werden, was für eine mobile Erfassung aus Kostengründen keinen Sinn macht. Der Sensor ist gut sichtbar, was bei den Verkehrsteilnehmern oft zu Irritationen führt (abruptes Abbremsen, Ausweichen, bewusstes Bremsen auf den Leitungen um diese zu zerstören). Auch dieser Sensor unterliegt einem hohen Verschleiß. Bei einem magnetischen Schleifendetektor ist nachteilig, dass seine Installation ein Öffnen der Straße erfordert. Er ist auch anfällig gegen Beschädigung infolge thermischer Ausdehnung der Straße und nicht ausgelegt, dicht aufeinander fahrende Fahrzeuge unterscheiden zu können.

Schließlich sind auch Erdmagnetfeldsysteme einsetzbar. Dies werden mittels einer Schutzmatte auf der Fahrbahn montiert, wobei ein interner Akku die energetische Versorgung gewährleistet. Der Akku kann nur ca. 10 Tage Daten erfassen. Das System ist in der Anschaffung teuer, da alle elektronischen Komponenten in dem System integriert sind. Beschädigungen an diesem System sind nur mit hohem Kostenaufwand zu beheben. Zudem werden derartige Systeme auf Dauer durch die darüber fahrenden Fahrzeuge / Räumfahrzeuge zerstört.

Vorrichtungen, die die Registrierung von Fahrzeugen bzw. von fahrzeugbezogenen Daten erleichtern, sind in mehreren Patentanmeldungen und Patenten bereits beschrieben. Beispielsweise beschreibt die DE 198 17 008 A1 ein Verfahren und eine Anordnung zur Analyse von Verkehr sowie einen Sensor hierfür. Die Erfassung der Messdaten basiert bei der darin beschriebenen Vorrichtung auf einem Magnetfelddetektor, bestehend aus einem oder mehreren magnetisch variablen Widerständen. Ein erster Magnetfeldsensor enthält einen magnetisch variablen Widerstand der seinen Widerstand dann ändern kann, wenn er einem Magnetfeld ausgesetzt ist. Der magnetisch variable Widerstand weist eine Vorspannung auf, wobei ein Wechsel im Widerstand entsprechend dem angewendeten Magnetfeid von einem Verstärker detektlert wird. Der Verstärker erzeugt ein erstes Analogsignal, welches die Widerstandsänderung des magnetisch variablen Widerstandes anzeigt. Mit Hilfe eines Mikroprozessors können die gezählten und gespeicherten Werte ausgewertet werden.

Auch die US 5,408,179 beschreibt eine Messvorrichtung auf Basis eines magnetischen Feldes. Bei dieser Vorrichtung ist ein Sensor vorgesehen, bei dem ein ferromagnetischer Streifen eine um ihn herum gewickeite leitende Wicklung aufweist. Ein Permanentmagnet ist neben einem Ende des ferromagnetischen Streifens angeordnet. Der Magnet magnetisiert den ferromagnetischen Streifen. Ein elektronischer Schaltkreis erzeugt ein analoges Signal, das repräsentativ für die Induktivität der Wicklung ist, wenn das Erdmagnetfeid gestört wird. Ein anderer elektronischer Kreis digitalisiert zu bestimmten Zeitintervallen das analoge Signal, um eine Reihe digitalisierender Werte zu erzeugen. Der Mikroprozessor verarbeitet schließlich die ermittelten Werte. Bei dieser Vorrichtung besteht das Problem darin, dass die Sensoren Vormagnetisierungsfehler aufweisen und die gesamte Vorrichtung, die in die Straße eingesetzt wird aufgrund der notwendigerweise genau aufeinander abgestimmten Bauteile aufwendig und teuer ist.

Nachteilig bei allen beschriebenen Vorrichtungen ist, dass ihr Aufbau verhältnismäßig kompliziert ist und sie in relativ kurzen Zeitintervallen durch Fachpersonal überprüft werden müssen. Die einzeinen Komponenten sind oftmals teuer und gegenüber Umwelteinflüssen, wie Frost, Wasser und hohen Temperaturen sehr anfällig. Auch hat sich gezeigt, dass gerade die mit den Messvorrichtungen, also den Induktionsschleifen oder den Schläuchen verbundenen Geräte häufig Opfer von Vandalismus werden. Es Ist notwendig, diese gegen Diebstahl und Zerstörung zu schützen, eine Anordnung in stabilen Kästen, die vorzugsweise verschließbar sind, ist daher die Regel. Durch diese Schutzmaßnahmen werden die Kosten weiterhin erhöht. Schließlich ist bei den bekannten Vorrichtungen die Erstinstallation zeitaufwendig und bedingt meist eine Sperrung der Straße. Dies ist insbesondere dann der Fall, wenn es sich um erdverlegte, also innerhalb der Fahrzeugdecke angeordnete Messvorrichtungen handelt. Schließlich sind nahezu alle bekannten Vorrichtungen sehr empfindlich gegenüber Umwelteinflüssen wie Frost, Wasser und hohen Temperaturen.

Die US 5 554 907 beschreibt eine Vorrichtung zur Messung der Geschwindigkeit von Fahrzeugen, die eine Messvorrichtung aufweist, die auf eine Straßenoberfläche gelegt werden kann. In dieser Messvorrichtung sind piezo-elektrische Elemente angeordnet, die durch überfahrende Fahrzeuge aktiviert werden und ihre gemessenen Daten per Funk übermitteln. Die notwendige Energie wird dabei durch die Bewegungsenergie der Fahrzeuge erzeugt. Nachteilig bei dieser Vorrichtung ist, dass die Messvorrichtung lediglich auf der Straße aufliegt und durch Bleigewichte an ihrer Position gehalten werden soll. Falls gewünscht, können die Enden der Messvorrichtung mit Hilfe von Klebestreifen zusätzlich auf dem Untergrund befestigt werden. Somit ist eine sichere Ortsfeste Anordnung nicht gegeben. Dies kann dazu führen, dass sich die Messvorrichtung mit der Zeit von der Oberfläche abhebt, war wiederum insbesondere für Zweiradfahrer zu erheblichen Gefahren führen kann.

Auch in der WO 2005/072476 A2 ist ein System zur Signalerzeugung beschrieben bei dem ein piezo-elektrisches Element aktiviert wird und ein Funksignal an einem Empfänger sendet. In dieser Druckschrift ist auch beschrieben, dass ein solches piezo-elektrisches Element in eine Straßenoberfläche eingebettet sein kann. Ein Einbetten in eine Straßenoberfläche ist jedoch kostenaufwendig und mit zeltlichem Aufwand verbunden. Eine Möglichkeit einer sinnvollen Befestigung auf einer Straßenoberfläche ist nicht beschrieben.

Ferner offenbart die DE 10 2004 036729 A1 ein Datenermittlungssystem, bei dem jede Messvorrichtung (= Fahrzeugsensor) ein Piezoelement und eine elektronische Verarbeitungseinheit umfasst. Diese Verarbeitungseinheit dient zum Auswerten, Speichern und Verwalten von mit dem Piezoelement aufgenommenen Sensorsignalen und daraus gewonnenen Verkehrsdaten und umfasst einen Programmspeicher sowie eine Vorrichtung zum Ausführen von Programmen. Durch das Piezoelement bzw. einen durch das Piezoelement gespeisten Energiespeicher wird ferner die Verarbeitungseinheit mit Strom versorgt. Auch weist jede Messvorrichtung eine Sende- und Empfangseinheit auf. Mehrere solcher Messvorrichtungen können in einem Kommunikationsnetzwerk miteinander verbunden werden, wobei auch ein Verkehrsdatenaustausch zwischen den Messvorrichtungen vorgesehen ist, und die Messvorrichtungen ein Ad-hoc-Netz ausbilden können, in dem jede Messvorrichtung die Übermittlungsfunktion übernehmen kann.

Die Aufgabe der vorliegenden Erfindung besteht darin, eine Vorrichtung zur Ermittlung von Daten zu schaffen, die zum einen kostengünstig herstellbar ist, zum anderen soll die Vorrichtung vor Ort schnell und einfach zu installieren sein und auch im laufenden Betrieb nur geringe Kosten verursachen. Die Wartung und Instandhaltung muss schnell und einfach durchführbar sein und die Wartungsintervalle sollen möglichst lang sein. Weiterhin soll die Vorrichtung gegenüber Umwelteinflüssen und Vandalismus möglichst resistent sein. Schließlich soll die Vorrichtung für eine Verkehrsdatenerfassung einsetzbar sein.

Erfindungsgemäß wird die Aufgabe durch ein Datenermittlungssystem mit den Merkmalen des Anspruchs 1 gelöst.

Die Vorrichtung eignet sich zur Ermittlung nahezu beliebiger Daten. Wesentlich ist nur, dass die für die Messung und das Aussenden des Funksignals notwendige elektrische Energie ausschließlich von Fahrzeugen geliefert wird, die mit der Messvorrichtung in Kontakt kommen.

Möglich ist auch, dass die Vorrichtung zwar die Bewegungsenergie von Elementen nutzt, jedoch von diesen unabhängige Daten, beispielsweise Umweltdaten, klimatische Daten usw., ermittelt.

Eine wesentliche Erkenntnis der Erfindung besteht also darin, dass die erfindungsgemäße Vorrichtung aufgeteilt ist in ein Mess- und Sendemodul und ein Empfangsmodul, wobei das Mess- und Sendemodul völlig unabhängig von einer externen Energiequelle ist. Das Mess- und Sendemodul, das aus der Messvorrichtung und dem Funkmodul besteht, benötigt weder Batterien oder Akkumulatoren, noch ist ein Anschluss an ein öffentliches Stromnetz notwendig. Gerade darin besteht ein erheblicher Vorteil der Erfindung, da alle mit der elektrischen Versorgung zusammenhängenden Nachteile vermieden werden. Gerade elektrische Verbindungselemente (Kontakte) sind besonders sensibel gegenüber Umwelteinflüssen wie Frost, Feuchtigkeit und hohen Temperaturen. Ebenfalls ist das Auftreten von Störungen aufgrund aufgetrennter Kabel ausgeschlossen. Schließlich hat sich auch gezeigt, dass elektrische Geräte aufgrund der nutzbaren einzelnen Komponenten häufig gestohlen oder zerstört werden.

Das Mess- und Sendemodul weist eine Folie mit Piezo-elektrischen Eigenschaften auf, beispielsweise eine Folie aus polarisiertem Polymer. Die Folie ist von einem widerstandsfähigem Material umgeben, dass als Schutzhülle wirkt. Es hat sich gezeigt, dass ein so gebildeter Leiter mit einer Breite von etwa 5 mm und einer Höhe bzw. Dicke von 1 bis 2 mm ausreicht, um die notwendige Energie zur elektrischen Versorgung des Funkmoduls zu gewährleisten. Als Schutzhüllenmaterial eignet sich insbesondere ein Metallmaterial. Die Messvorrichtung bzw. der Leiter ist sehr kostengünstig herstellbar. Die erfindungsgemäße Vorrichtung eignet sich insbesondere für eine Verkehrsdatenerfassung. Die Messvorrichtung wird auf die Straßendecke aufgebracht, ein Einbringen in die Straßendecke mit allen damit verbundenen Nachteilen kann dadurch vermieden werden. Erfindungsgemäß erfolgt ein Aufkleben auf die Fahrbahn mit Hilfe eines Klebebandes, so dass die Messvorrichtung zwischen der Straßenoberfläche und dem Klebeband eingeschlossen ist. Die Messvorrichtung wird vollständig vom Klebeband umhüllt auf die Straßenoberfläche aufgeklebt.

Eine besonders widerstandsfähige und wirkungsvolle Verklebung lässt sich mit einem Klebeband aus Glasfaserkunststoff (GFK), das mit Hilfe eines Klebers auf Bitumenbasis geklebt wird, erreichen. Ein solches Glasfaserkunststoff-Bitumen-Klebeband ist dann, wenn es auf einer Straße aus Asphalt aufgebracht ist, nahezu unlösbar mit diesem verbunden. Ein wesentlicher Vorteil bei der Befestigung der Messvorrichtung mit einem Klebeband besteht darin, dass eine Sperrung der Straße nicht notwendig ist. Das Aufkleben der Messvorrichtung ist in wenigen Sekunden durchführbar, eine Rotphase einer Ampelkreuzung kann hierfür ausreichen, eine Sperrung der Straße mit allen damit verbundenen Nachteilen und Risiken kann vermieden werden.

An einem Ende der Messvorrichtung ist das Funkmodul angeordnet. Dieses sendet nur dann, wenn ein elektrischer Impuls durch ein über die Messvorrichtung fahrendes Fahrzeug erzeugt wurde. Das Funksignal bzw. das Funktelegramm wird von einem Funkempfänger empfangen, der im Umfeld des Funkmoduls angeordnet ist. Wesentlich ist, dass jedes Funktelegramm nicht nur die fahrzeugbezogenen Daten beinhaltet, sondern auch Daten aufweist, die eine eindeutige Zuordnung zu der mit dem jeweiligen Funkmodul verbundenen Messvorrichtung ermöglicht. Dies bedeutet, dass in einem Kreuzungsbereich eine Vielzahl von Messvorrichtungen verlegt werden können, vorzugsweise auf jeder einzelnen Fahrspur der Straße, jedoch nur ein Funkempfänger zentral im Kreuzungsbereich angeordnet werden muss. Da die Funktelegramme eine eindeutige Zuordnung zu den jeweiligen Messvorrichtungen erlauben, ist es möglich, fahrzeugbezogene Daten je Fahrspur zu ermitteln und auszuwerten.

Grundsätzlich kann das Funkmodul durch jedes Funkmodul gebildet sein, das in der Lage ist, Bewegungsenergie zu nutzen. Beispielsweise kann es durch einen energieunabhängigen elektromechanischen Funkschalter ausgebildet sein, der in der DE 102 56 156 A1 beschrieben ist. Batterielose Funkmodule werden von der Anmelderin der genannten Druckschrift, der Firma ENOcean beispielsweise unter der Bezeichnung PTM 100 vertrieben. Derartige Funkmodule versenden Funktelegramme, die eine Vielzahl an Informationen enthalten können. Zugehörige Funkempfänger, die das Funktelegramm empfangen und auslesen können, werden ebenfalls von der Firma ENOcean vertrieben, sie tragen die Bezeichnung RCM 110 bzw. RCM 120.

Um eine Manipulation und fehlerhafte Zuordnung der Funktelegramme zu verhindern, sind diese vorzugsweise verschlüsselt. Es hat sich gezeigt, dass eine 32 Bit-Verschlüsselung für die genannten Anforderungen geeignet ist. Ein wesentlicher Vorteil bei der Nutzung von Funktelegrammen besteht auch darin, dass diese nur dann abgesendet werden, wenn tatsächlich ein Energieimpuls erzeugt wird. Insofern ist es möglich, ein standardisiertes 868 MHz Funknetz zu nutzen, das verlangt, dass ein so genannter Duty cycle von 1 % nicht überschritten wird. Durch diese Beschränkung wird ein Dauerfunken vermieden, so dass auf diese Frequenz relativ wenige Interferenzen erzeugt werden. Die 868 MHz Funkfrequenz ist für die Nutzung der Erfindung besonders geeignet, es können aber selbstverständlich auch andere Frequenzen für das Übersenden der Funktelegramme verwendet werden.

Eine weitere Vereinfachung der Installation der Vorrichtung vor Ort kann auch dadurch erreicht werden, dass die Messvorrichtungen mit Hilfe von nummerierten Klebebändern auf die Straße aufgebracht werden. Die Messvorrichtungen bzw. die Leiter, die das Piezo-Element enthalten, können bereits mit dem Klebeband verbunden bzw. von diesem umhüllt sein, wenn sie an ihrem Bestimmungsort transportiert werden. Dies hat den Vorteil, dass eine Software, die die Funktelegramme auswertet, bereits im Vorfeld programmiert werden kann. Wird beispielsweise eine stark befahrene und große Kreuzung mit dem erfindungsgemäßen Datenermittlungssystem bestückt, ist schon im Vorfeld klar, welche Messvorrichtung auf welcher Spur der Kreuzung installiert sein wird. Dies erleichtert zum einen die Programmierung und Simulation der Verkehrserfassung, sie erleichtert aber auch die Arbeiten vor Ort. Nachdem alle Messvorrichtungen an ihrem Platz bzw. auf ihrer jeweiligen Spur angebracht wurden, ist es nur noch notwendig, den Funkempfänger an einem Ort aufzustellen, den alle Funktelegramme erreichen können. Die oben genannten Funkmodule haben beispielsweise eine Reichweite von etwa 300 m.

Der Funkempfänger ist das einzige Bauteil, das eine Energieversorgung benötigt. Diese kann beispielsweise durch Batterien, Akkumulatoren oder durch einen Anschluss an das öffentliche Stromnetz gewährleistet werden. Es eignet sich insbesondere auch die Ausnutzung regenerativer Energien, wie beispielsweise Sonnen oder Windenergie.

Aufgrund der schnellen und einfachen Installation vor Ort und auch aufgrund der äußerst geringen Materialkosten eignet sich die erfindungsgemäße Vorrichtung insbesondere auch für eine Bestückung von Fahrradwegen. Dabei ist auch von Vorteil, dass die mit Klebeband aufgebrachten Messvorrichtungen von einem Radfahrer aufgrund der geringen Höhe nicht als störend empfunden werden. Im Gegensatz zu bisher preferierten Druckschlauchlösungen geht auch von denen mit dem Radweg fest verbundenen Messvorrichtung keine Gefahr aus. Druckschläuche können sich lösen oder sie können gelöst werden, was sie zu einer Gefahr für die Radfahrer werden lassen kann.

In einer besonders vorteilhaften Ausführungsvariante werden je Fahrspur zwei Messvorrichtungen mit einem gewissen Abstand zueinander angeordnet. Dadurch, dass ein Fahrzeug die beiden Messvorrichtungen nacheinander passiert, kann auf die Fahrtrichtung rückgeschlossen werden, auch kann die Geschwindigkeit des Fahrzeugs berechnet werden. Möglich ist auch, dass zwei Messvorrichtungen nur einem Funkmodul zugeordnet sind, wobei dieses dann die ermittelten Daten je nach Ausführung je nach Messvorrichtung differenziert oder undifferenziert versendet.

In einer besonders vorteilhaften Ausführungsvariante führt ein Bewegungsimpuls dazu, dass die Messvorrichtung neben den element- bzw. fahrzeugbezogenen Daten auch Umgebungsdaten ermittelt und über das Funksignal oder- telegramm z.B. bitcodiert für eine weitere Auswertung versendet. Derartige Umweltdaten können beispielsweise CO-, CO₂-, NOₓ- sowie Feinstaubkonzentrationen, Temperatur, Luftfeuchtigkeit, Tausalzkonzentration oder akustische Daten wie entstandener Geräuschpegel sein.

Anhand der nachfolgenden Figuren wird die Erfindung näher erläutert. Dabei sollen die gezeigten Ausführungsvarianten lediglich beispielhaft zu verstehen, die Erfindung ist nicht auf diese beschränkt.

Es zeigen:
- Fig. 1:: eine Prinzipdarstellung einer Straßenkreuzung ausgestattet mit erfindungsgemäßen Vorrichtungen,
- Fig. 2:: eine Messvorrichtung im Querschnitt,

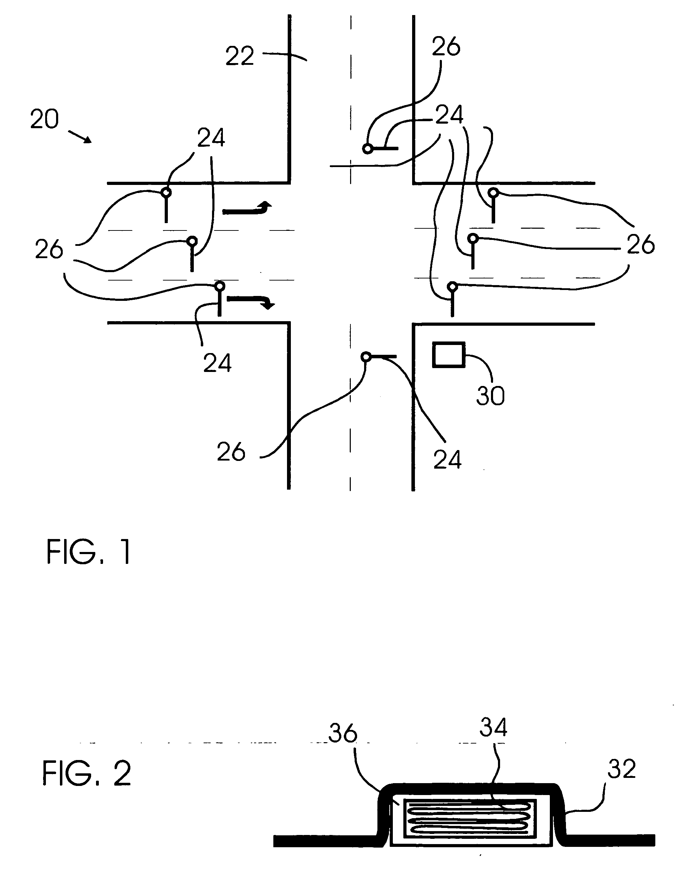

Figur 1 verdeutlicht beispielhaft die Anordnung eines erfindungsgemäßen Datenermittlungssystems 20. Auf einer Fahrbahnoberfläche 22 sind Messvorrichtungen 24 angeordnet, die jeweils ein Funkmodul 26 aufweisen und gemeinsam ein Mess- und Sendemodul ausbilden. Im gezeigten Ausführungsbeispiel weist die Fahrbahnoberfläche 22 mehrere Fahrspuren auf, auf denen jeweils ein Mess- und Sendemodul angeordnet ist. Alternativ wäre auch die Anordnung von nur einem Mess- und Sendemodul über die gesamte Fahrzeugbreite möglich, dies hätte aber zum Nachteil, dass eine Ermittlung von fahrzeugbezogenen Daten oder eine Zählung der Fahrzeuge selbst nicht separat für jede einzelne Fahrspur möglich wäre.

Die Funkmodule 26 weisen keine eigene Energiequelle auf, sondern werden von den Messvorrichtungen 24 mit Energie versorgt. Die notwendige Energie wird durch die mechanische Spannung erzeugt, den nicht gezeigte Fahrzeuge auf die Messvorrichtungen 24 ausüben. Aufgrund eines piezoelektrischen Effekts entsteht ausreichend elektrische Energie, um dem Funkmodul 26 zu ermöglichen, ein Funktelegramm auszusenden. Das Funktelegramm enthält diejenigen Daten, die ausgewertet werden sollen, beispielsweise die Dauer der mechanischen Belastung, die Stärke der mechanischen Belastung usw. Weiterhin weist das Funktelegramm eine eindeutige Zuordnung zur zugehörigen Messvorrichtung 24 auf. Vorzugsweise ist das Funktelegramm verschlüsselt, es hat sich eine Verschlüsselung mit 32 Bit als sinnvoll erwiesen.

Die erzeugten Funktelegramme werden von einem Funkempfänger 30 empfangen, der in Funkreichweite der Funkmodule 26 angeordnet ist. Der Funkempfänger 30 weist eine externe Energiequelle, beispielsweise Batterien, Akkumulatoren oder ein Anschluss an das öffentliche Stromnetz auf. Der Funkempfänger 30 kann nahezu beliebig ausgeführt sein, beispielsweise kann er einen Datenspeicher aufweisen, in dem die empfangenen Funktelegramme abgelegt und gespeichert werden. Sie können dann in regelmäßigen Abständen durch ein externes Gerät ausgelesen und weiterverarbeitet werden. Der Funkempfänger 30 kann aber auch selbst ein Funkmodul 26 aufweisen, über das die Funktelegramme an einen weiteren Empfänger gesendet werden. Beispielsweise kann der Funkempfänger 30 auch über das Internet Daten versenden oder über dieses ausgelesen werden. Dies hätte den Vorteil, dass ein Auslesen von Daten vor Ort nicht mehr notwendig wäre.

Der Funkempfänger 30 sollte derart angeordnet sein, dass eine sichere Funkverbindung zu den Modulen 26 gegeben ist. Dies ist insbesondere dann der Fall, wenn der Funkempfänger 30 relativ nahe am Boden angeordnet ist, da dann ledigilch die Räder und Reifen der Fahrzeuge die jeweiligen Funkstrecken unterbrechen.

Theoretisch kann sogar Über die Impulsstärke bzw. über den ausgeübten Druck auf die Messvorrichtungen 24 auf die Fahrzeugart rückgeschlossen werden. Beispielsweise üben Lkw's einen höheren Druck als Motorräder oder Kleinwagen aus. Auch ist es möglich, je Fahrspur zwei oder mehr Messvorrichtungen 24 vorzusehen, um dann auch die Geschwindigkeit der Fahrzeuge und den Abstand zu anderen Fahrzeugen messen zu können.

Die Befestigung der Messvorrichtungen 24 auf der Fahrbahnoberfläche 22 erfolgt vorzugsweise durch Klebung. Ein Klebeband 32, dargestellt in Figur 2, wird im einfachsten Fall auf die Messvorrichtung 24 und die Fahrbahnoberfläche 22 geklebt, so dass die Messvorrichtung 24 zwischen dem Klebeband 32 und der Fahrbahnoberfläche 22 eingeschlossen ist. Gemäß Figur 2, die eine Messvorrichtung 24 im Querschnitt zeigt, kann das Klebeband 32 die Messvorrichtung 24 aber auch vollständig umhüllen. Im gezeigten Ausführungsbeispiel ist die Messvorrichtung 24 durch ein piezoelektrisches Material 34, zum Beispiel eine Piezofolie gebildet, die von einer Schutzhülle 36 umgeben ist. Das piezoelektrisches Material 34 kann einlagig, mehrlagig oder wie im gezeigten Ausführungsbeispiel gezeigt, gefaltet ausgeführt sein. Das Klebeband 32 besteht aus einem widerstandsfähigem Material und einem Klebstoff, der für eine Verbindung mit der jeweiligen Fahrbahnoberfläche 22 geeignet ist. Eine besonders widerstandsfähige Verbindung ergibt sich bei Asphaltstraßen durch Verwendung eines Glasfaserkunststoffklebebandes, das mit einem Bitumenkleber auf die Fahrbahnoberfläche 22 gekiebt wird.

Die Abmessungen sind mit ca. 50 mm x 500mm x 5mm wesentlich geringer als die Abmessungen von heute üblichen Sensoren in der Verkehrserfassung. Die Vorrichtung 20 ist wesentlich leichter zu montieren, ist durch ihre geringe Bauhöhe kaum wahrzunehmen und stellt auch für Zweiradfahrer keine Gefährdung dar. Es ist keine externe Energieversorgung notwendig.

## Patentansprüche

1. Datenermittlungssystem (20), aufweisend
- mehrere Messvorrlchtungen (24), die
- derart auf einem Untergrund angeordnet sind, dass Fahrzeuge über diese hinwegfahren und jeweils ihre masse auf die Messvorrichtungen (24) wirkt,
- die durch die wirksame masse mechanische Spannung In elektrische Energie umwandeln, wobei jede Messvorrichtung (24) ein Funkmodul (26) aufweist, das Funksignale versendet, die die gemessenen Informationen enthalten,
- einen Funkempfänger (30) zum Empfang der Funksignale der Funkmodule (26) der Messvorrichtungen, wobei der Funkempfänger (30) In Funkreichweite entfernt von den Messvorrichtungen (24) angeordnet ist,
**dadurch gekennzeichnet, dass**
- die jeweilige Messvorrichtung (24)
● ein piezoelektrisches Material in Follenform umfasst, das von einer Schutzhülle (36) umgeben ist,
● mit Hilfe eines Klebebandes (32) fest mit dem Untergrund verbunden ist, und
● vollständig zwischen dem Klebeband (32) und dem Untergrund eingeschlossen ist,
- die von dem Funkmodul (26) ausgesendeten Funksignale jeweils nur an den Funkempfänger (30) gesendet werden, wenn aufgrund des piezoelektrischen Effekts des piezoelektrischen Materials ein Energieimpuls durch ein über die Messvorrichtung fahrendes Fahrzeug erzeugt wird und die Funksignale neben den gemessenen Informationen, die ausgewertet werden sollen, Informationen beinhalten, die der mit diesem Funkmodul (26) verbundenen Messvorrichtung (24) empfängerseitig eindeutig zuzuordnen sind, und
- die Messvorrichtung (24) und das Funkmodul (26) ausschließlich mit der durch die wirksame Masse elektrischen Energie betrieben werden.

2. Datenermittlungssystem (20) nach Anspruch 1, **dadurch gekennzeichnet, dass** das piezoelektrische Material (34) durch eine polarisierte Polymerfolie gebildet ist.

3. Datenermittlungssystem (20) nach Anspruch 1, **dadurch gekennzeichnet, dass** die Piezo-Folie (34) innerhalb der Schutzhülle (36) gefaltet ist.

4. Datenermittlungssystem (20) nach einem der Ansprüche 1 bis 3, **dadurch gekennzeichnet, dass** mehrere Piezofolien (34) in ihren Schutzhüllen (36) innerhalb eines Gewebebandes (32) angeordnet sind.

## Claims

1. A data acquisition system (20), comprising
- several measuring devices (24), which
- are disposed on an underground in such a way that vehicles drive over them and their mass respectively acts on the measuring devices (24),
- convert the mechanical tension generated by the effective mass into electrical energy, each measuring device (24) comprising a radio module (26) transmitting radio signals containing the measured information,
- a radio receiver (30) for receiving the radio signals of the radio modules (26) of the measuring devices, the radio receiver (30) being disposed distant from the measuring devices (24) within the radio range,
**characterised in that**
- the respective measuring device (24)
● comprises a piezoelectric material in the form of a film, which is enveloped by a protective sleeve (36),
● is firmly connected to the underground by means of an adhesive tape (32), and
● is completely enclosed between the adhesive tape (32) and the underground,
- the radio signals transmitted by the radio module (26) are respectively transmitted only to the radio receiver (30) if, due to the piezoelectric effect, an energy pulse is generated by a vehicle driving over the measuring device, and the radio signals, in addition to the measured information that are to be evaluated, contain information that can be uniquely attributed by the receiver to the measuring device (24) connected to this radio module (26), and
- the measuring device (24) and the radio module (26) are operated solely by the electrical energy generated by the effective mass.

2. A data acquisition system (20) according to claim 1, **characterised in that** the piezoelectric material (34) is formed by a polarized polymer film.

3. A data acquisition system (20) according to claim 1, **characterised in that** the piezo film (34) is folded within the protective sleeve (36).

4. A data acquisition system (20) according to any one of the claims 1 to 3, **characterised in that** several piezo films (34) in their protective sleeves (36) are disposed within a fabric belt (32).

## Revendications

1. Système de détermination de données (20), comprenant
- une pluralité de dispositifs de mesure (24) qui
- sont disposés sur un sol de telle sorte que des véhicules roulent sur ceux-ci et que leur masse agisse respectivement sur les dispositifs de mesure (24),
- transforment en énergie électrique la tension mécanique générée par la masse efficace, chacun des dispositifs de mesure (24) présentant un module radio (26) qui émet des signaux radio contenant les informations mesurées,
- un récepteur radio (30) de réception des signaux radio des modules radio (26) des dispositifs de mesure, ledit récepteur radio (30) étant disposé de manière à être espacé à portée radio des dispositifs de mesure (24),
**caractérisé par le fait que**
- le dispositif de mesure (24) respectif
● comprend un matériau piézoélectrique sous forme de feuille qui est enveloppé d'une enveloppe protectrice (36),
● est solidarisé au sol à l'aide d'un ruban adhésif (32) et
● est enfermé complètement entre ledit ruban adhésif (32) et le sol,
- les signaux radio émis par ledit module radio (26) ne sont émis respectivement au récepteur radio (30) que lorsque, en raison de l'effet piézoélectrique du matériau piézoélectrique, une impulsion d'énergie est générée par un véhicule roulant sur le dispositif de mesure et que les signaux radio contiennent, outre les informations mesurées qui doivent être évaluées, des informations qui sont à associer clairement, côté récepteur, au dispositif de mesure (24) relié à ce module radio (26), et
- ledit dispositif de mesure (24) et le module radio (26) fonctionnent exclusivement à l'énergie électrique générée par la masse efficace.

2. Système de détermination de données (20) selon la revendication 1, **caractérisé par le fait que** ledit matériau piézoélectrique (34) est constitué par une feuille polymère polarisée.

3. Système de détermination de données (20) selon la revendication 1, **caractérisé par le fait que** la feuille piézoélectrique (34) est pliée à l'intérieur de ladite enveloppe protectrice (36).

4. Système de détermination de données (20) selon l'une quelconque des revendications 1 à 3, **caractérisé par le fait que** plusieurs feuilles piézoélectriques (34) dans leurs enveloppes protectrices (36) sont disposées à l'intérieur d'une bande de tissu (32).
